# DEMANDE DE BREVET EUROPEEN

(11) **EP 2 749 527 A1**
(43) Date de publication de la demande: **02.07.2014**
(21) Numéro de dépôt: 13199028.5
(22) Date de dépôt: 20.12.2013
(51) Int. Cl.: B81C 99/00

(54) **Procédé de réalisation d'un reseau microfluidique**

(30) Priorité: 28.12.2012 FR 1262930
(71) Demandeur: Commissariat à l'Énergie Atomique et aux Énergies Alternatives, 75015 Paris (FR)
(72) Inventeur: Renaudot, Raphaël, 42000 SAINT ETIENNE (FR); Agache, Vincent, 38800 CHAMPAGNIER (FR); Fouillet, Yves, 38340 VOREPPE (FR)
(74) Mandataire: Augarde, Eric

(57) **Abrégé**

L'invention porte sur un procédé de réalisation d'un réseau microfluidique comportant au moins un canal de section semi-circulaire, comportant les étapes suivantes :
- mise en contact d'un premier liquide (7) avec un réseau d'électrodes (3) d'une puce microfluidique (1) comprenant au moins une paire d'électrodes (3a, 3b) sensiblement parallèles et coplanaires disposées sur un substrat (4),
- activation dudit réseau d'électrodes de manière à actionner par diélectrophorèse liquide LDEP ledit premier liquide pour former une structure fluidique (9) comprenant au moins un doigt fluidique (9a), et
- utilisation de ladite structure fluidique comme un moule pour réaliser ledit réseau microfluidique par solidification ou durcissement d'un deuxième liquide (11) déposé sur la puce microfluidique et épousant la forme de ladite structure fluidique.

## Description

### DOMAINE TECHNIQUE

La présente invention concerne le domaine général de la microfluidique et plus particulièrement, la réalisation de réseaux microfluidiques comportant des canaux de section demi-ronde.

### ÉTAT DE LA TECHNIQUE ANTÉRIEURE

Dans de nombreux domaines, on cherche à manipuler et analyser des échantillons liquides de petit volume de la manière la plus simple et la moins intrusive possible. Ce peut être le cas, par exemple, pour établir des interactions biologiques et/ou chimiques entre des solutions pour une analyse chimique, un diagnostic biologique ou médical, ou encore dans le domaine du génie génétique ou agro-alimentaire.

Dans ces domaines, on manipule en général un écoulement de liquides dans des composants microfluidiques comportant des canaux et chambres, grâce à des actionneurs externes aux composants, de types pompes, contrôleurs en pression, ou pousse-seringues.

Ce genre de composants met généralement en oeuvre une technologie de type MEMS. Les canaux sont réalisés par assemblage de deux plaques, avec au moins l'une des deux gravée et structurée par exemple, par photolithographie pour former les rainures souhaitées.

Selon une autre technologie, moins pertinente car de résolution beaucoup moins élevée, les canaux sont réalisés par micro-usinages sur une carte plastique de type PMMA puis recouvert d'un capot.

Les canaux peuvent aussi être réalisés en coulant des matériaux réticulants de type PDMS sur des moules préalablement usinés par les méthodes précédemment citées.

Dans tous ces dispositifs connus, la géométrie du réseau fluidique est définie à la conception. En outre, leur fabrication nécessite des équipements du type salle blanche impliquant des moyens et des temps de fabrications importants. Pour une nouvelle géométrie de composants, il faut donc effectuer un nouveau cycle long et coûteux de conception et de réalisation.

La demande de brevet WO2009/130274 de la demanderesse résout ce problème en proposant un procédé de fabrication de canaux microfluidiques, de façon programmable et reconfigurable, en utilisant les techniques de déplacement par électromouillage EWOD (ElectroWetting On Dielectric) ou par diélectrophorèse liquide LDEP *(Liquid DiElectroPhoresis).* Plus particulièrement, deux fluides non miscibles, dont l'un pouvant être solidifié, sont introduits entre deux plaques munies d'électrodes. Un des fluides est déplacé selon la technique EWOD ou LDEP et lorsque les canaux souhaités sont formés, le phénomène de durcissement est activé pour figer la formation de ces canaux fluidiques. La section des canaux fabriqués par cette méthode est rectangulaire.

Toutefois, des canaux à section arrondie ou semi-circulaire sont particulièrement utiles par exemple dans la fabrication des pompes microfluidiques comme décrites par exemple dans l'article Unger et al, « Monolithic microfabricated valves and pumps by multilayer soft lithography », Science vol 288: 113-116 (2000).

Cependant, il est difficile de mettre en oeuvre une méthode contrôlée et reproductible pour réaliser des structures hémisphériques. Pour former des canaux de section arrondie, il existe une technique décrite par exemple par Unger et al., dans le document intitulé « Monolithic Microfabricated Valves and Pumps by Multilaer Soft Lithography », Science 288 : 113-116 (2000). Cette technique consiste à utiliser d'abord la méthode de photolithographie pour graver des rainures sur un substrat de résine. Ensuite, une étape supplémentaire appelée « fluage de résine » est utilisée pour ramollir la résine et la déformer aux niveaux des bords des canaux voulus, de sorte à obtenir des canaux plus arrondis.

Toutefois, le fluage de résine est une étape difficile à contrôler, longue, et nécessite une optimisation pour chaque épaisseur de résine et pour chaque type de résine. L'épaisseur de résine est souvent limitée à quelques dizaines de µm (souvent 10 µm) car c'est une étape de micro-fabrication, non développée à la base pour cette application et pour ces ordres de grandeurs. De plus, il est difficile de contrôler exactement les hauteurs des canaux formés à partir de cette technique, et encore plus difficile de varier intentionnellement la hauteur des canaux sur un même substrat. Les dimensions voulues (hauteur et largeur) des canaux sont aussi très limitées par le biais de cette technique. Ainsi, la technique de fluage est difficile à maîtriser et est non reproductible à toutes les dimensions de canaux voulues. En outre, les résines sont visqueuses et donc la forme des canaux est plus en patatoïde qu'en section semi-circulaire.

L'objet de la présente invention est de remédier aux inconvénients précités en proposant un procédé simple et précis pour la fabrication de canaux microfluidiques de section semi-circulaire, de façon programmable et reconfigurable.

### EXPOSÉ DE L'INVENTION

L'invention a pour objet un procédé de réalisation d'un réseau microfluidique comportant au moins un canal de section semi-circulaire, comportant les étapes suivantes :
- mise en contact d'un premier liquide avec un réseau d'électrodes d'une puce microfluidique comprenant au moins une paire d'électrodes sensiblement parallèles et coplanaires disposées sur un substrat,
- activation dudit réseau d'électrodes de manière à actionner par diélectrophorèse liquide LDEP ledit premier liquide pour former une structure fluidique comprenant au moins un doigt fluidique, et
- utilisation de ladite structure fluidique comme un moule pour réaliser ledit réseau microfluidique par solidification ou durcissement d'un deuxième liquide déposé sur la puce microfluidique et épousant la forme de ladite structure fluidique.

Ainsi, le procédé utilise la technique de diélectrophorèse liquide LDEP dans une configuration ouverte pour générer de manière rapide des doigts fluidiques de section semi-circulaire. En effet, les sections des doigts fluidiques sont naturellement semi-circulaires car le champ électrique contraint le premier liquide à aller vers le gap séparant les deux électrodes. De plus les dimensions (hauteur et largeur) de ces doigts fluidiques peuvent varier sur une gamme très large allant de quelques centaines de nanomètres à plusieurs centaines de micromètres. Les doigts fluidiques sont ensuite utilisés pour réaliser par moulage et de manière simple, reproductible, programmable et reconfigurable, des réseaux microfluidiques comportant des canaux de section hémisphérique.

Selon un premier mode de réalisation, ledit premier liquide possède une propriété de durcissement et ledit procédé comporte les étapes suivantes :
- durcissement dudit premier liquide matérialisant ladite structure fluidique tout en maintenant le réseau d'électrodes en activation pendant l'étape de durcissement afin de figer ladite structure fluidique, et
- écoulement du deuxième liquide sur ladite structure fluidique figée.

Selon ce premier mode de réalisation, la structure fluidique est figée avant l'introduction du deuxième liquide évitant ainsi toute interaction entre les deux liquides et formant un moule structurel de haute précision permettant par exemple de réaliser de manière simple une pluralité de réseaux microfluidiques identiques sans la nécessité de recommencer le processus d'actionnement du premier liquide.

Avantageusement, le premier liquide est un matériau à changement de phase liquide-solide sélectionné parmi les matériaux suivants : colle à base d'époxy ou de silicone ou de résine, colle UV, gel, polymère réticulant, paraffine, agarose, gélatine, cires, et wax.

Ainsi, le premier liquide peut être sélectionné parmi un grand choix de matériaux à changement de phase à une température comprise par exemple entre 0°C et 150°C.

Avantageusement, le premier liquide est une colle UV et le durcissement dudit premier liquide est réalisé par insolation sous un rayonnement UV à une longueur d'onde adaptée à la longueur d'onde de réticulation de ladite colle UV.

Ainsi, la structure fluidique peut être figée à distance et de manière simple et rapide sans le recours à une source de chaleur.

Avantageusement, le procédé comporte une étape de fusion du matériau durci ou solidifié dudit premier liquide afin de reconfigurer la structure fluidique.

Ainsi, en inversant le processus de durcissement on peut recommencer le procédé en réutilisant la puce microfluidique pour réaliser une structure fluidique présentant une géométrie différente.

Selon un deuxième mode de réalisation, le deuxième liquide est non miscible au premier liquide de sorte que l'interface entre les deux liquides prend la forme de ladite structure fluidique sous l'effet de l'activation dudit réseau d'électrodes, le premier liquide étant recouvert par le deuxième liquide.

Selon ce deuxième mode de réalisation, l'interface entre les deux liquides non miscibles est avantageusement utilisée comme une empreinte qui se matérialise par le durcissement du deuxième liquide formant ainsi de manière simple le réseau microfluidique.

Avantageusement, le premier liquide est de l'eau déionisée, de l'eau, un liquide organique, un solvant, ou une solution aqueuse.

Ainsi, on utilise un liquide dont l'actionnement par la technique LDEP ne nécessite pas une activation à haute fréquence et qui peut ensuite être facilement évacué après le durcissement du deuxième liquide.

Avantageusement, le deuxième liquide est un matériau à changement de phase liquide-solide sélectionné parmi les matériaux suivants : polymères réticulants, paraffine, agarose, gélatine, cires, wax, colle à base d'époxy ou de silicone ou de résine, colle UV, et gel.

Ainsi, le deuxième liquide peut être sélectionné parmi un grand choix de matériaux à changement de phase pour réaliser des réseaux microfluidiques de haute qualité.

Avantageusement, la géométrie du réseau microfluidique est programmable par l'activation des électrodes de manière indépendante. Ainsi, à partir d'une seule puce microfluidique, on peut réaliser une pluralité de réseaux fluidiques présentant différentes géométries.

Avantageusement, la forme et/ou les dimensions dudit au moins un doigt fluidique du réseau microfluidique est configurable en fonction de la forme et/ou la largeur et/ou le nombre d'électrodes. Ainsi, on peut réaliser des canaux fluidiques de toute forme, largeur, ou hauteur.

Avantageusement, au cours d'un même actionnement par diélectrophorèse liquide, ledit au moins un doigt fluidique peut être réalisé avec des dimensions variables. Ainsi, avec un même actionnement LDEP, on peut réaliser des canaux fluidiques comportant différentes zones présentant différentes longueurs et/ou profondeurs et/ou largeurs.

Avantageusement, ledit réseau microfluidique est utilisé comme plaque modèle pour réaliser d'autres réseaux microfluidiques.

Ainsi, le réseau microfluidique peut être utilisé pour la fabrication d'un moule afin de réaliser de manière simple une pluralité de réseaux fluidiques identiques.

L'invention vise un procédé de réalisation d'un réseau microfluidique comportant au moins un canal de section semi-circulaire, comportant les étapes suivantes :
- placement d'une goutte mère d'un premier liquide possédant une propriété de durcissement sur une position initiale d'un réseau d'électrodes comprenant au moins une paire d'électrodes sensiblement parallèles et coplanaires disposées sur un substrat d'une puce microfluidique,
- activation dudit réseau d'électrodes de manière à actionner par diélectrophorèse liquide LDEP ledit premier liquide pour former une structure fluidique comprenant au moins un doigt fluidique,
- durcissement dudit premier liquide matérialisant ladite structure fluidique tout en maintenant le réseau d'électrodes en activation afin de figer ladite structure fluidique,
- écoulement d'un deuxième liquide sur la puce microfluidique recouvrant ladite structure fluidique figée,
- durcissement du deuxième liquide pour réaliser le réseau microfluidique, et
- démoulage du réseau microfluidique.

L'invention vise également un procédé de réalisation d'un réseau microfluidique comportant au moins un canal de section semi-circulaire, comportant les étapes suivantes:
- placement des premier et deuxième liquides non miscibles sur une surface libre d'une puce microfluidique comprenant un réseau d'électrodes ayant au moins une paire d'électrodes sensiblement parallèles et coplanaires, le deuxième liquide possédant une propriété de durcissement,
- activation dudit réseau d'électrodes de manière à actionner par diélectrophorèse liquide LDEP ledit premier liquide pour former une structure fluidique comprenant au moins un doigt fluidique, l'interface entre les premier et deuxième liquides prenant la forme de ladite structure fluidique,
- durcissement dudit deuxième liquide recouvrant ladite structure fluidique tout en maintenant le réseau d'électrodes en activation de sorte que l'empreinte de la structure fluidique se retrouve dans le deuxième liquide durci formant ainsi le réseau fluidique, et
- décollement du réseau microfluidique de la puce microfluidique.

Avantageusement, le procédé comporte les étapes suivantes :
- assemblage du réseau microfluidique à un support pour réaliser un composant microfluidique, et
- réalisation d'au moins un trou dans ledit assemblage pour créer une entrée fluidique.

L'invention porte également sur un dispositif microfluidique comportant un réseau microfluidique réalisé selon l'une quelconque des caractéristiques précédentes.

D'autres avantages et caractéristiques de l'invention apparaîtront dans la description détaillée non limitative ci-dessous.

### BRÈVE DESCRIPTION DES DESSINS

On décrira à présent, à titre d'exemples non limitatifs, des modes de réalisation de l'invention, en se référant aux dessins annexés, dans lesquels :
Les Figs. 1A-1G illustrent de manière schématique un procédé de réalisation d'un réseau microfluidique, selon l'invention ;
Les Figs. 2A-2F illustrent de manière schématique la formation d'une structure fluidique sur un réseau d'électrodes digitalisées, selon l'invention ;
Les Figs. 3A-3C illustrent de manière schématique la formation d'une structure fluidique sur un réseau d'électrodes en configuration continue, selon l'invention ;
La Fig. 4 illustre de manière schématique un exemple d'une puce microfluidique pour la réalisation d'un réseau microfluidique, selon l'invention ;
Les Figs. 5A-5J illustrent de manière schématique un procédé de réalisation d'un réseau microfluidique, selon un premier mode de réalisation de l'invention, en référence à une coupe longitudinale de la puce microfluidique de la Fig. 4 ;
Les Figs. 6A-6E illustrent de manière schématique un procédé de réalisation d'un réseau microfluidique, selon un deuxième mode de réalisation de l'invention, en référence à une coupe transversale de la puce microfluidique de la Fig. 4.

### EXPOSÉ DÉTAILLÉ DES MODES DE RÉALISATION PRÉFÉRÉS

Le principe de l'invention est de prendre avantage de l'actionnement d'un liquide par diélectrophorèse LDEP dans une configuration ouverte pour mouler des réseaux microfluidiques comportant des canaux de section semi-circulaire.

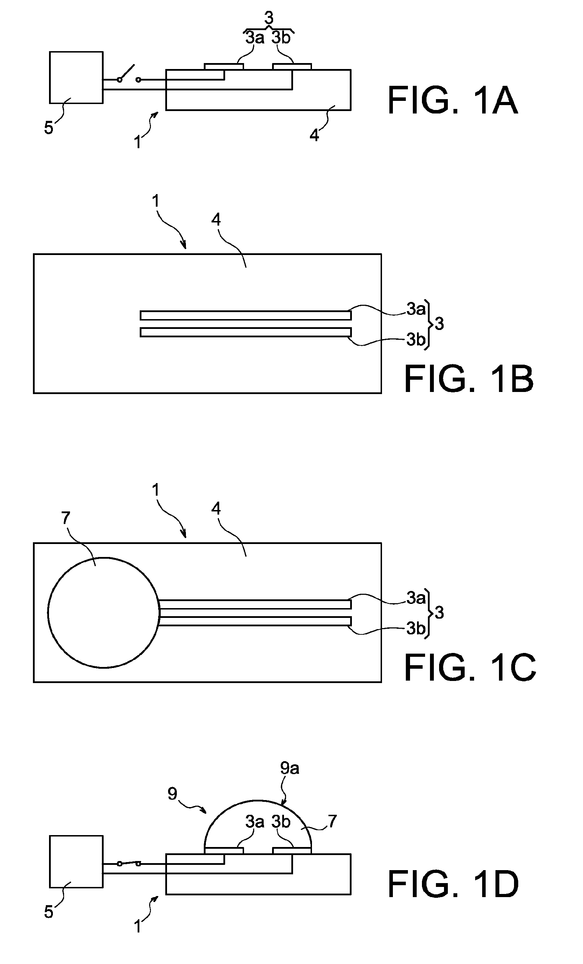

Les Figs. 1A-1G illustrent de manière schématique un procédé de réalisation d'un réseau microfluidique, selon l'invention.

Plus particulièrement, la Fig. 1A représente, en coupe, une puce microfluidique 1 comportant un réseau d'électrodes 3 disposé sur un substrat 4. Le réseau d'électrodes 3 comprend au moins une paire d'électrodes 3a, 3b de déplacement sensiblement parallèles et coplanaires. La Fig. 1B représente, une vue de dessus, de la puce microfluidique, selon une échelle plus petite que celle de la Fig. 1A.

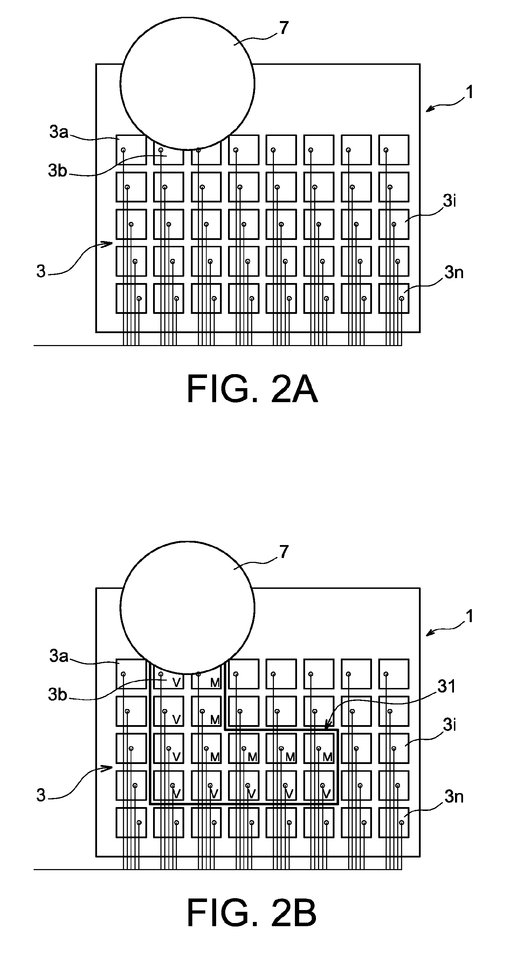

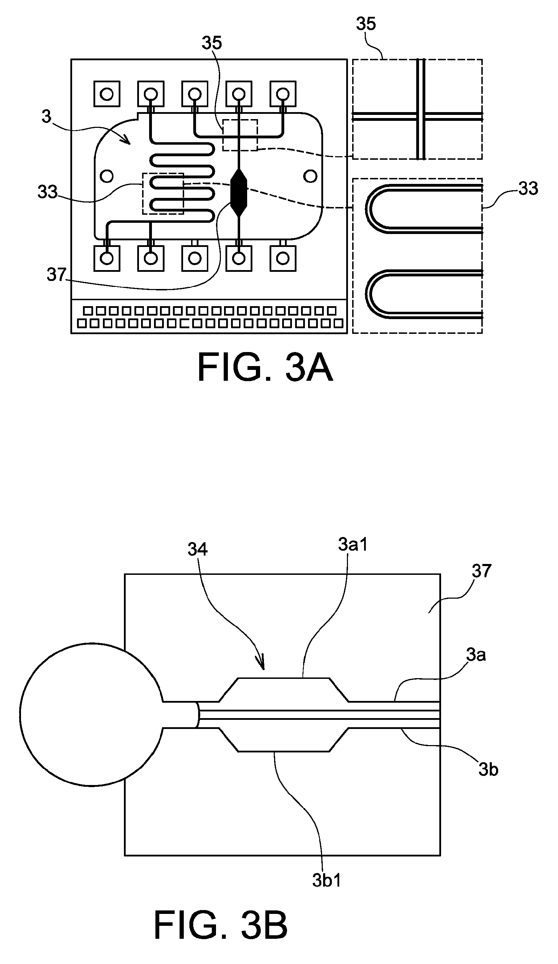

Par paire d'électrodes, on entend soit une paire d'électrodes continue, s'étendant selon un chemin donné (voir Figs. 3A-3C), soit une pluralité d'électrodes élémentaires adjacentes (voir Figs. 2A-2E). Dans ce dernier cas, chaque électrode est séparée de sa voisine par un faible espacement, compris entre le dixième de la largeur de l'électrode et deux fois la largeur de l'électrode.

Le réseau d'électrodes 3 est par ailleurs connecté à une interface électrique 5 permettant d'appliquer des différences de potentiel entre les électrodes 3a, 3b. Le réseau d'électrodes 3 est ainsi configuré pour former par diélectrophorèse liquide *LDEP,* sous l'effet d'une activation électrique, au moins un doigt fluidique le long des électrodes activées.

Par diélectrophorèse liquide LDEP, on entend l'application d'une force électrique, générée par un champ électrique oscillant non uniforme, sur un liquide. La formation d'un doigt fluidique par diélectrophorèse liquide est notamment décrite dans l'article de Jones intitulé « Liquid dielectrophoresis on the microscale », J. Electrostat, 51-52 (2001), 290-299. Lorsque le liquide est situé dans un champ électrique, les molécules du liquide acquièrent un dipôle non nul et se polarisent. Dans la mesure où le champ est non uniforme, une force de Coulomb apparaît et induit le déplacement des molécules du liquide, et ainsi de tout le liquide, vers un maximum de champ. Le liquide est alors naturellement contraint par le champ électrique d'avoir une section semi-circulaire.

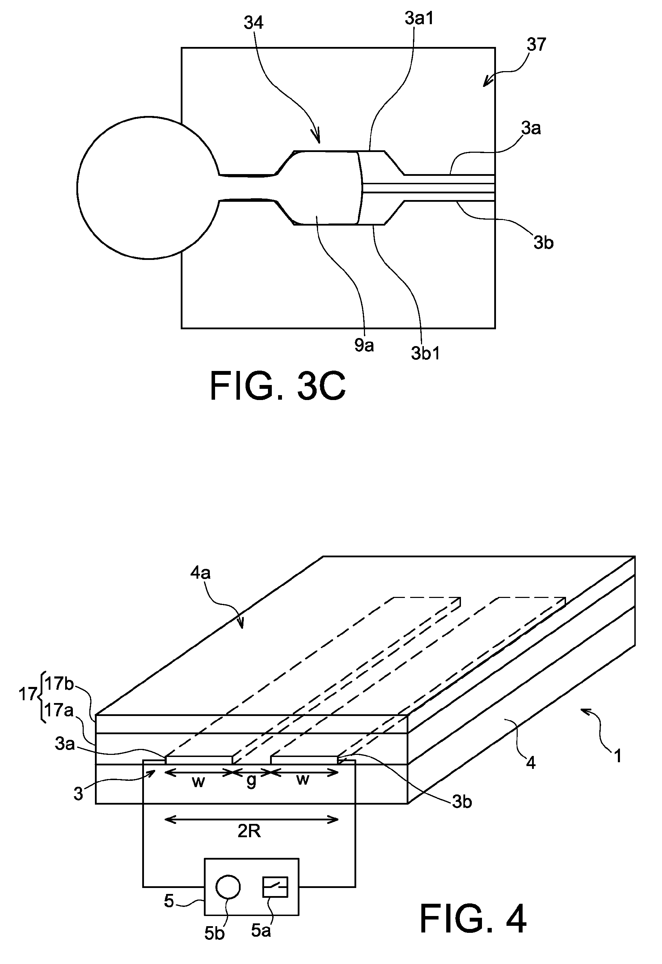

La Fig. 1C est une vue de dessus représentant une mise en contact d'un premier liquide 7 plus ou moins électriquement isolant, avec le réseau d'électrodes 3. Plus particulièrement, le premier liquide 7 correspond à une goutte mère, de volume important, située en amont du chemin fluidique. On notera que lorsque le premier liquide 7 n'est pas électriquement isolant, il est avantageux d'ajouter sur le substrat une couche diélectrique de passivation (voir Fig. 4) recouvrant les électrodes afin d'empêcher tout phénomène d'électrolyse. De préférence, les électrodes sont recouvertes d'une couche d'un matériau hydrophobe, tel SiOC, Téflon ou Parylène, l'épaisseur de la couche étant par exemple compris entre 100 nm et 1 µm. Cette couche hydrophobe est destinée à entrer en contact avec le liquide manipulé par LDEP et permet d'obtenir une goutte de forme hémisphérique. Elle est isolante. La couche hydrophobe est isolante et peut être déposée sur une autre couche isolante recouvrant les électrodes (voir Fig. 4), par exemple Si0₂, Si₃N₄, résine de photolithographie par exemple SU8. L'épaisseur de cette autre couche isolante est comprise entre 100 nm et 1 µm et est destinée à prévenir un claquage dans la couche hydrophobe.

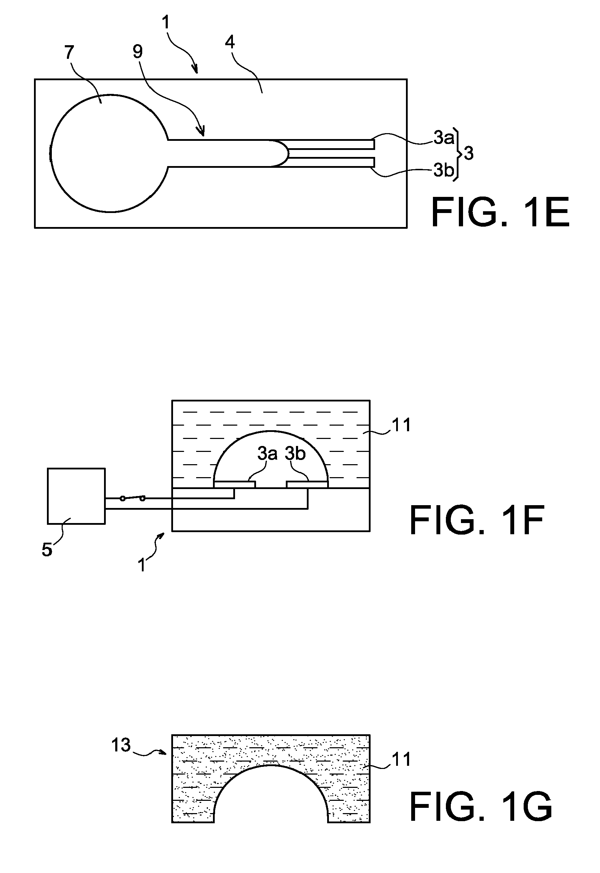

La Fig. 1D est une vue en coupe et la Fig. 1E est une vue de dessus représentant l'activation du réseau d'électrodes 3 par l'application d'une tension alternative. La fréquence de la tension est comprise entre, par exemple, quelques hertz (pour les liquides les moins conducteurs) et quelques mégahertz, par exemple entre 10 kHz et 10 MHz (pour les liquides les plus conducteurs), et d'une tension préférentielle de quelques volts RMS à quelques centaines de volts RMS. Le plus souvent, la fréquence appliquées n'excède pas quelques centaines de kHz. Lorsque le liquide 7 est très isolant, avec par exemple une conductivité inférieure à 10⁻⁹ S.m⁻¹, la fréquence seuil d'actionnement est de l'ordre du Hz. La tension peut même être continue dans le cas d'un liquide très isolant.

Ainsi, sous l'effet du champ électrique, le premier liquide 7 est étiré par diélectrophorèse liquide pour former une structure fluidique 9 comprenant au moins un doigt fluidique 9a (voir aussi Figs. 2B-3C) et de section semi-circulaire le long d'un chemin défini par les électrodes 3a, 3b activées.

La Fig. 1F montre que la structure fluidique 9 est utilisée comme un moule pour réaliser le réseau microfluidique à partir d'un deuxième liquide 11 déposé sur la puce microfluidique 1 et épousant la forme de la structure fluidique 9. Le deuxième liquide 11 est composé d'un matériau à changement de phase liquide-solide qui peut être un polymère réticulant de type PDMS, une paraffine de type CₙH₂ₙ₊₂, une agarose, une gélatine, un gel, une cire, une colle à base d'époxy ou de silicone ou de résine, ou une colle UV.

Ainsi, la solidification (ou durcissement) du deuxième liquide 11 qui forme l'enceinte environnante de la structure fluidique 9 engendre une structure tridimensionnelle solide dont la forme épouse le doigt fluidique. Autrement dit, le doigt fluidique constitue une empreinte ou un moule, définissant la forme du deuxième liquide durcit. A ce stade, l'activation électrique est stoppée, ce qui entraîne le retrait du doigt liquide alors que la structure solidifiée du deuxième liquide reste intègre. Cette dernière forme alors un réseau microfluidique 13 comportant au moins un canal fluidique 13a de section sensiblement semi-circulaire, comme illustré sur la Fig. 1G. Ce réseau peut être mis en oeuvre dans des applications de microfluidique continue (i.e., ne nécessitant pas forcément l'actionnement d'une électrode pour forcer un écoulement).

On notera que le réseau microfluidique 13 peut aussi être utilisé comme plaque modèle pour réaliser d'autres réseaux microfluidiques.

Les Figs. 2A-2F illustrent de manière schématique la formation d'une structure fluidique sur un réseau d'électrodes digitalisées, selon l'invention.

La Fig. 2A est une vue de dessus représentant une puce microfluidique 1 sur laquelle est déposée une goutte de liquide 7. Selon cet exemple, la puce microfluidique 1 comporte un réseau d'électrodes 3 comprenant une pluralité d'électrodes 3a, 3b,..., 3i,..., 3n discontinues ou digitalisées en forme de pixels, disposées de manière matricielle, chaque pixel 3i de cette matrice d'électrodes étant adressable indépendamment des autres pixels. Ainsi, à partir d'un même réseau 3 bidimensionnel d'électrodes, et notamment de type matriciel, on peut former une grande variété de réseaux microfluidiques avec des géométries variées. Plus la matrice d'électrodes est dense, plus la résolution géométrique du canal et la complexité du réseau fluidique pourront être élevées.

Les Figs. 2B-2F donnent des exemples de géométrie de réseaux fluidiques réalisables sur la même puce microfluidique représentée sur la Fig. 2A.

L'exemple de la Fig. 2B montre l'activation d'un sous ensemble de pixels 3i formant un chemin 31 à angle droit. Les pixels 3i situés sur une bordure du chemin 31 sont mis à la masse M tandis que ceux situés sur l'autre bordure sont traversés par une tension V non uniforme. D'une façon générale, le chemin fluidique s'étend le long de couples de pixels coplanaires, chaque couple étant constitué d'une électrode et d'une contre-électrode, entre lesquelles le potentiel varie.

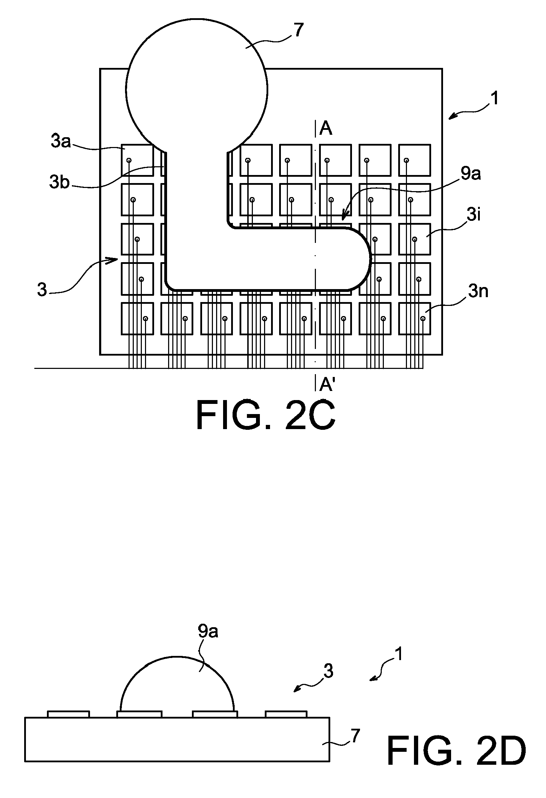

La Fig. 2C montre que le doigt fluidique 9a issu de la goutte mère s'étend le long du chemin 31 défini par le sous-ensemble de pixels 3i activés. On notera qu'avantageusement, les effets capillaires font que les formes anguleuses des chemins définis par les pixels 3i activés vont se traduire par des formes arrondies ou incurvées du doigt fluidique 9a. Ainsi, on peut former un réseau fluidique 13 en évitant des formes anguleuses qui sont parfois indésirables en microfluidique.

Par ailleurs, la Fig. 2D est une section selon le plan AA' de la Fig. 2C montrant que la section du doigt fluidique est naturellement semi-circulaire.

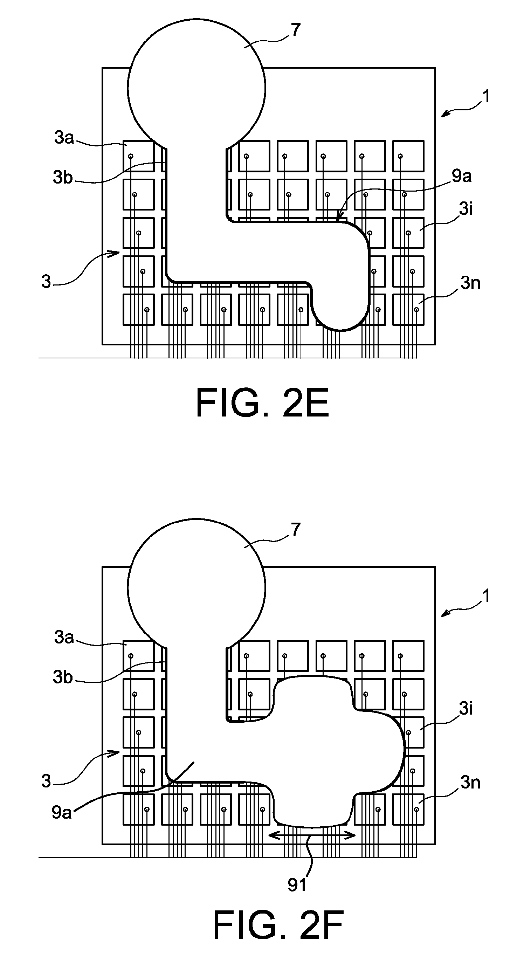

L'exemple de la Fig. 2E montre la formation d'un doigt fluidique 9a selon un autre chemin déterminé par l'activation d'un autre sous-ensemble de pixels 3i. La géométrie (forme et dimensions) de la structure fluidique 9 peut donc être facilement programmable en activant les électrodes de manière indépendante permettant ainsi de réaliser une grande variété géométrique de réseaux microfluidiques.

Ainsi la présente invention permet de réutiliser la même puce microfluidique 1 pour créer des moules matérialisés par des structures fluidiques 9 de différentes formes géométriques.

On peut également contrôler les hauteurs d'un doigt fluidique 9a sur une même puce microfluidique 1 en variant le nombre d'électrodes 3i activées. En effet, l'exemple de la Fig. 2F montre que le rayon R de la section circulaire sur une zone 91 du doigt fluidique 9a peut être augmenté en activant des pixels 3i supplémentaires sur cette zone 91.

Ainsi, la forme géométrique et/ou les dimensions d'un doigt fluidique 9a peuvent être configurables en fonction de la forme et/ou le nombre d'électrodes 3i activées et/ou la largeur des électrodes 3a, 3b (voir aussi Fig. 3B).

Par ailleurs, les Figs. 3A-3C illustrent de manière schématique la formation d'une structure fluidique sur un réseau d'électrodes en configuration continue, selon l'invention.

Sur la Fig. 3A est représentée une puce microfluidique 1 comportant un réseau d'électrodes 3 de géométrie particulière.

Le réseau d'électrodes 3 en configuration continue peut avoir des formes complexes comportant par exemple des électrodes en forme de serpentins 33, des électrodes ayant des coudes à angles droits ou en forme de croisement 35, et des électrodes de largeur variable 37.

Les doigts fluidiques issus des gouttes mères s'étendent les longs des différents chemins déterminés par les paires d'électrodes activées. Alors, il est possible de former de manière simple et en une seule opération des canaux de différentes dimensions et de différentes formes pour pratiquement toutes les applications microfluidiques. Par exemple, on peut réaliser un réseau microfluidique comportant un canal avec un palier et/ou une chambre et/ou une section convergente et/ou une section divergente et/ou une constriction et/ou un canal en forme de serpentin.

L'exemple de la Fig. 3B illustre une paire d'électrodes 3a, 3b rectilignes et coplanaires présentant une largeur variable. Plus particulièrement, la paire d'électrodes 3a, 3b présente une zone 34 large formée de protubérances planes 3a1, 3b1 qui s'étendent vers l'extérieur de chaque électrode 3a, 3b. Les protubérances 3a1, 3b1 sont disposées de manière symétrique l'une par rapport à l'autre et appartiennent chacune à une électrode différente. On notera que le rayon de la section semi-circulaire du doigt fluidique 9a qui s'étend sur la paire d'électrodes est égal à la distance entre les bordures extérieures des électrodes 3a, 3b. Le doigt fluidique 9a présente alors un rayon plus grand au niveau des protubérances 3a1, 3b1, comme illustré sur la Fig. 3C.

Il est possible alors d'envisager différentes formes et dimensions des doigts fluidiques 9a en faisant varier le nombre et la géométrie des électrodes 3i, 3a, 3b. En particulier, on peut varier les dimensions (longueurs, hauteurs, largeurs) des doigts fluidiques 9a au cours d'un même actionnement LDEP en activant des électrodes 3a, 3b de largeurs variables (Figs. 3B- 3C) ou en variant le nombre d'électrodes 3i activées (Fig. 2E). Par conséquent, on peut contrôler les dimensions des canaux sur un même moule.

On notera que dans l'état de la technique, les hauteurs des canaux sont définies par les procédés et les temps de gravure associés. Ainsi, pour varier la hauteur d'un canal, le seul moyen était de passer par plusieurs étapes de photolithographie nécessitant plusieurs masques, suivies de plusieurs étapes de gravures. Autrement dit, un nombre N de hauteurs de canaux différentes nécessitait la fabrication de N masques de photolithographie, de N étapes de photolithographie et d'autant étapes de gravures.

Sur la Fig. 4 est représenté un exemple plus détaillé d'une puce microfluidique pour la réalisation d'un réseau microfluidique, selon l'invention.

La puce microfluidique 1 comprend un substrat 4 présentant une surface libre 4a. Le matériau du substrat 4 peut être choisi parmi les matériaux suivants : le silicium, silicium monocristallin, silicium polycristallin, nitrure de silicium, oxyde de silicium, le verre, pyrex ou un matériau organique tel que le polycarbonate ou le PEEK, le plastique, le papier, le nickel, le tungstène, le platine, etc. L'épaisseur du substrat 4 peut être quelconque, comprise par exemple entre quelques dizaines de microns et quelques millimètres.

Le substrat 4 comporte un niveau métallique pour la définition d'un réseau d'électrodes 3 adapté à former par diélectrophorèse liquide des doigts fluidiques sur la surface libre 4a du substrat. Ces électrodes 3a, 3b sont des empreintes obtenues par dépôt, puis gravure d'une fine couche d'un semi-conducteur ou d'un métal qui peut être choisi parmi l'aluminium, le cuivre, l'or, le platine, l'ITO (Indium Tin Oxyde). L'épaisseur des électrodes 3a, 3b est de quelques dizaines de nm à quelques centaines de nm, par exemple de l'ordre de 200nm.

Le réseau d'électrodes 3 comporte au moins une paire d'électrodes 3a, 3b de déplacement parallèles entre elles et coplanaires, disposées au niveau de la surface libre 4a du substrat 4. La structure des électrodes permet de définir les zones où les forces d'électrophorèse vont agir. L'exemple de la Fig. 4 illustre une seule paire d'électrodes 3a, 3b de longueur par exemple de 1 mm à 2 mm.

Les bordures intérieures d'une paire électrodes sont espacées l'une de l'autre d'une distance g, par exemple de l'ordre de 4µm à 10µm. Chaque électrode présente une largeur notée w de l'ordre de 8µm à 20µm et par conséquent, en notant 2R la distance séparant les bordures extérieures des électrodes 3a, 3b, le rayon R donnée par R=w+g/2 de la section semi-circulaire du doigt fluidique est alors de l'ordre de 10µm à 25µm. En effet, lorsque la largeur w des électrodes est du même ordre de grandeur que leur espacement g, le doigt fluidique en tout point du trajet recouvre une zone inscrite entre les deux extrémités latérales des électrodes. Ainsi, les dimensions des canaux formés par les doigts fluidiques sont de l'ordre de 10µm à 25µm en termes de largeur et de profondeur. Il est aussi envisageable de former des canaux dont les dimensions (largeur, profondeur) sont comprises entre 1µm (voire en dessous du micromètre) jusqu'à plusieurs centaines de micromètres, par exemple 500µm.

Par ailleurs, les longueurs des doigts fluidiques et par conséquent celles des canaux peuvent être très conséquentes. En effet, on peut former des doigts fluidiques par LDEP sur des longueurs de plusieurs dizaines de millimètres. On peut même envisager de former des doigts fluidiques (et donc des canaux) de plusieurs dizaines de centimètres, tant que l'apport en liquide de la goutte mère est conservé.

Il est à noter que la formation d'un doigt fluidique est très rapide, avec une vitesse de déplacement du liquide de l'ordre de 0,1 à 10cm/s; il suffit de 50 à 500 ms seulement pour former un doigt fluidique de 5mm.

Après structuration du réseau d'électrodes 3, le substrat 4 peut avantageusement être recouvert par au moins une couche 17 diélectrique de passivation afin de se prémunir des risques d'électrolyse du premier liquide si ce dernier est électriquement conducteur.

La couche 17 de passivation peut être une couche isolante par exemple, un oxyde SiO₂ du nitrure (SiN, Si₃N₄), des résines, des films sec, du SiOC, des polymères hydrophobes type Teflon (marque déposée - tétra-fluoroéthylène) ou autres fluoropolymères, un polymère de poly-p-xylylène (parylène) un oxyde High-k déposé par procédé dit ALD (HfO₂ Al₂O₃, ZrO₂, SrTiO₃, BaTiO₃, Ba₍₁₋ₓ₎SrₓTiO₃ (BST)...), et présenter une épaisseur comprise entre quelques nm (par exemple 10 nm ou 25 nm) et quelques microns (par exemple 5 µm). Les oxydes High-k ont une permittivité diélectrique élevée, ce qui permet d'augmenter l'efficacité de la transduction. Elle permet d'éviter l'électrolyse du liquide si celui-ci était en contact direct avec le réseau d'électrodes 3.

De préférence, le substrat 4 est couvert par une double couche de passivation : une première couche 17a diélectrique par exemple de nitrure SiN (de 100 nm à 1 µm) et une deuxième couche 17b par exemple de SiOC ou de Téflon (de 100 nm à µm) pour ses propriétés hydrophobes formant la surface libre 4a du substrat 4. On notera que la couche hydrophobe permet au liquide d'avoir un angle de contact élevé notamment, supérieur à 90°.

En outre, le réseau d'électrodes 3 est connecté à une interface électrique 5 comportant des moyens commutateurs 5a et des moyens générateurs 5b de tension pour activer le réseau d'électrode 3 selon la configuration souhaitée.

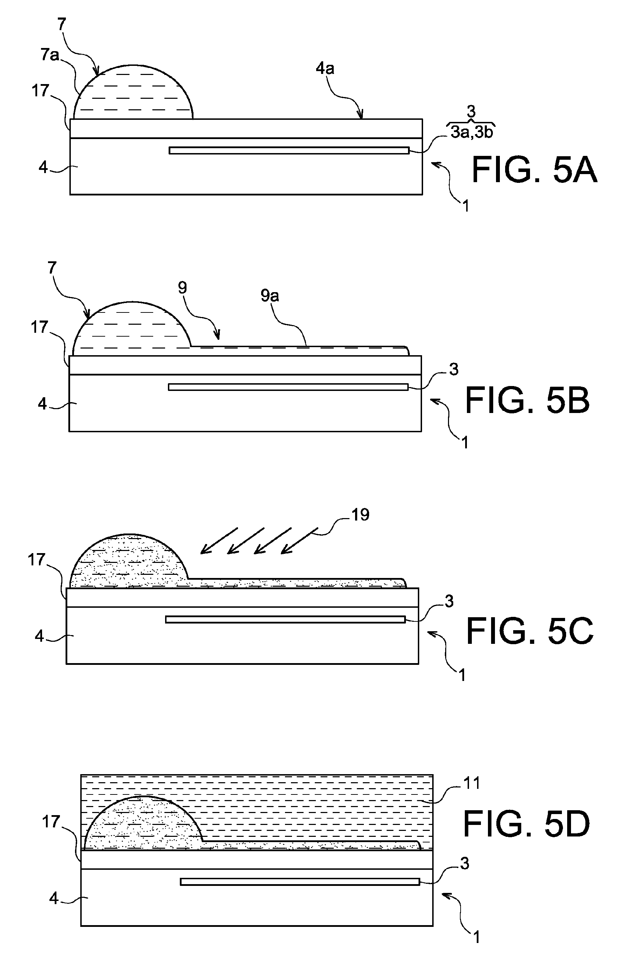

Les Figs. 5A-5J illustrent de manière schématique un procédé de réalisation d'un réseau microfluidique, selon un premier mode de réalisation de l'invention, en référence à une coupe longitudinale de la puce microfluidique de la Fig. 4.

Selon ce premier mode de réalisation, le premier liquide 7 possède une propriété de durcissement permettant de figer la structure fluidique 9 pendant l'activation des électrodes 3a, 3b.

A titre d'exemple, le premier liquide 7 est composé d'un matériau à changement de phase liquide-solide sélectionné parmi les matériaux suivants : colle à base d'époxy ou de silicone ou de résine, colle UV, gel (notamment alginate ou agarose), polymère réticulant par exemple de type PDMS, paraffine de type CₙH₂ₙ₊₂, gélatine, cire, wax.

Selon une première étape (Fig. 5A), on place une goutte mère 7a d'environ 1 µL d'un premier liquide 7 par exemple, une colle UV sur la surface libre 4a du substrat 4 au niveau du réseau d'électrodes 3. Plus particulièrement, on place la goutte mère 7a sur une position initiale correspondant par exemple au commencement d'une paire d'électrodes 3a, 3b de longueur de 1,5 mm. On notera qu'avant durcissement la colle UV est suffisamment fluide, présentant par exemple une fluidité comprise entre 1 centipoise et quelques centaines de centipoises, pour faciliter son actionnement par LDEP.

Ensuite, on active le réseau d'électrodes 3 en lui appliquant une tension adaptée pour générer un champ électrique oscillant et non uniforme de manière à actionner par LDEP le premier liquide 7. Ainsi, une structure fluidique 9 (Fig. 5B) comprenant au moins un doigt fluidique 9a de section semi-circulaire est formée sur le réseau d'électrodes 3.

En effet, l'exemple de la Fig. 5B montre que lorsqu'une tension sinusoïdale d'amplitude 500 V et de fréquence 50 kHz est appliquée entre les électrodes 3a, 3b, un doigt fluidique 9a (de colle UV) de section semi-circulaire s'étend en un temps très court (de l'ordre de la seconde) le long de la paire d'électrodes 3a, 3b. Le doigt fluidique 9a recouvre sensiblement la paire d'électrodes 3a, 3b sur toute leur longueur, et présente une largeur de contact sensiblement égale à la distance 2R définie précédemment et correspondant à la distance séparant les bordures extérieures des deux électrodes 3a, 3b.

Ensuite, après la formation de la structure fluidique 9, on opère un processus de durcissement ou de solidification du premier liquide 7 matérialisant la structure fluidique 9 tout en maintenant le réseau d'électrodes 3 en activation afin de figer la structure fluidique 9. Le processus de durcissement ou de solidification du premier liquide 7 peut être réalisé par un changement de température, ou par insolation sous une gamme de rayonnement spécifique en fonction du matériau utilisé pour le premier liquide 7.

En effet, l'exemple de la Fig. 5C montre qu'après le déplacement du doigt fluidique (de colle UV), ce dernier est insolé pendant au moins une minute par le rayonnement 19 d'une lampe UV (non représentée) à une longueur d'onde adaptée à la longueur d'onde de réticulation de la colle UV. Après le durcissement du premier liquide 7, la lampe UV est éteinte et l'alimentation des électrodes 3 est coupée. Le doigt fluidique 9a est dorénavant complètement solide et joue le rôle de moule pour fabriquer un canal fluidique.

En effet, dès que la structure fluidique 9 est formée et durcie, le deuxième liquide 11 par exemple du PDMS est coulé (Fig. 5D) sur la puce microfluidique 1 en recouvrant la structure fluidique 9 figée.

Ensuite, on opère un processus de durcissement ou de solidification du deuxième liquide 11 par changement de température, séchage, ou radiation (selon le matériau utilisé) pour réaliser le réseau microfluidique.

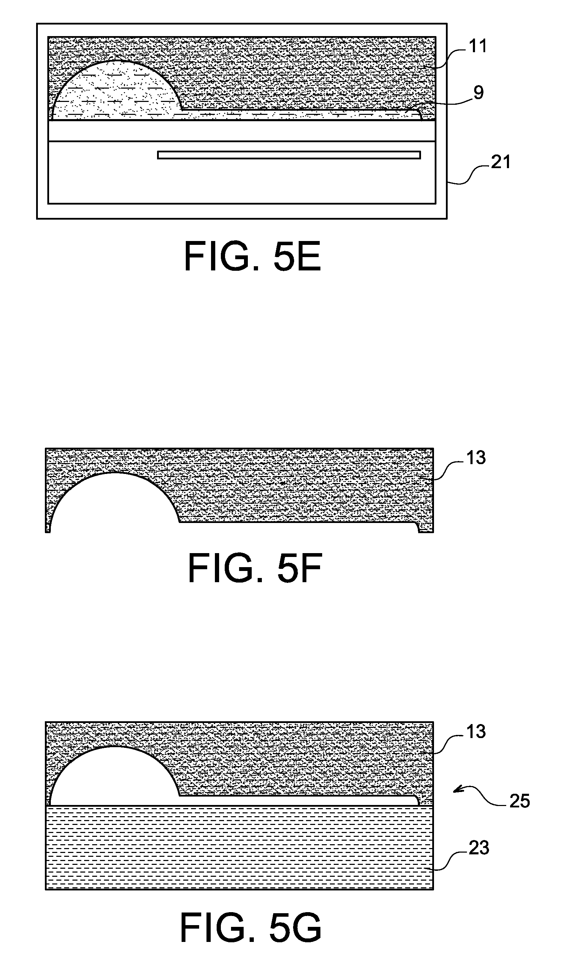

L'exemple de la Fig. 5E montre que l'ensemble de la puce microfluidique 1 et du deuxième liquide 11 recouvrant la structure fluidique 9 figée est mis en étuve 21 pendant par exemple une heure à 80°C pour faire répliquer le matériau PDMS du deuxième liquide. En variante, l'ensemble peut être mis à l'air libre pendant 24h. L'empreinte de la structure 9 en colle UV figée se retrouve donc dans le PDMS réticulé.

L'exemple de la Fig. 5F montre le réseau microfluidique 13 en PDMS réticulé après démoulage ou décollage de la puce microfluidique 1.

Ensuite, la Fig. 5G montre que le réseau microfluidique 13 en PDMS réticulé est assemblé à un autre support 23, par exemple un autre support PDMS réticulé à surface lisse pour réaliser un composant microfluidique 25. L'assemblage est réalisé par exemple à l'aide d'un plasma 02, suivi d'une mise en étuve pendant 2h à 60°C.

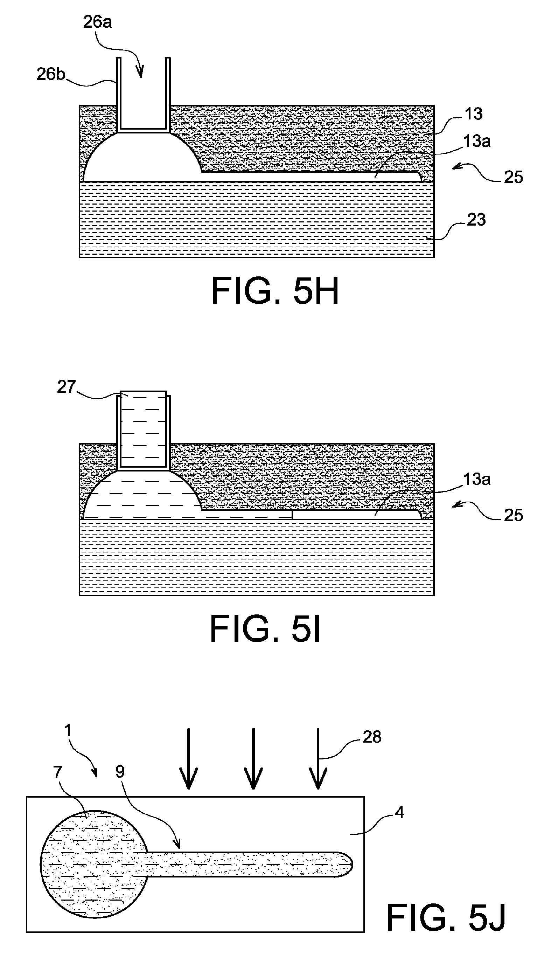

La Fig. 5H montre la réalisation d'un trou dans l'assemblage du composant microfluidique par exemple, au niveau de la position initiale de la goutte mère pour créer une entrée fluidique 26a. Un capillaire 26b est inséré dans ce trou, le capillaire 26 pouvant ensuite être relié à un pousse-seringue, un contrôleur en pression, une vanne ou un tout autre équipement fluidique (non représenté).

L'exemple de la Fig. 5I montre le remplissage du canal fluidique 13a par un liquide d'intérêt 27 via l'entrée fluidique 26a.

Avantageusement, on peut reconfigurer les moules un nombre de fois illimité tant que les actionnements fluidiques peuvent être réalisés, c'est-à-dire, tant que le réseau d'électrodes 3 et l'éventuelle couche de passivation 17 ne sont pas endommagés. En effet, les phénomènes de durcissement (pour par exemple la colle UV) ou de solidification (pour par exemple la paraffine) sont réversibles. On peut par exemple liquéfier la paraffine en la chauffant et on peut dissoudre la colle UV avec une solution décapante (par exemple, acétone ou piranha) et ainsi reconfigurer le réseau microfluidique 13, en créant un nouveau réseau différent du premier.

L'exemple de la Fig. 5J montre le décapage ou lavage 28 à l'acétone, du moule en colle UV durci (i.e., de la structure fluidique 9 figée) précédemment constitué afin de réaliser un autre moule conformément à ce qui a été décrit ci-dessus, dans la même configuration de canaux ou dans une configuration de canaux différente.

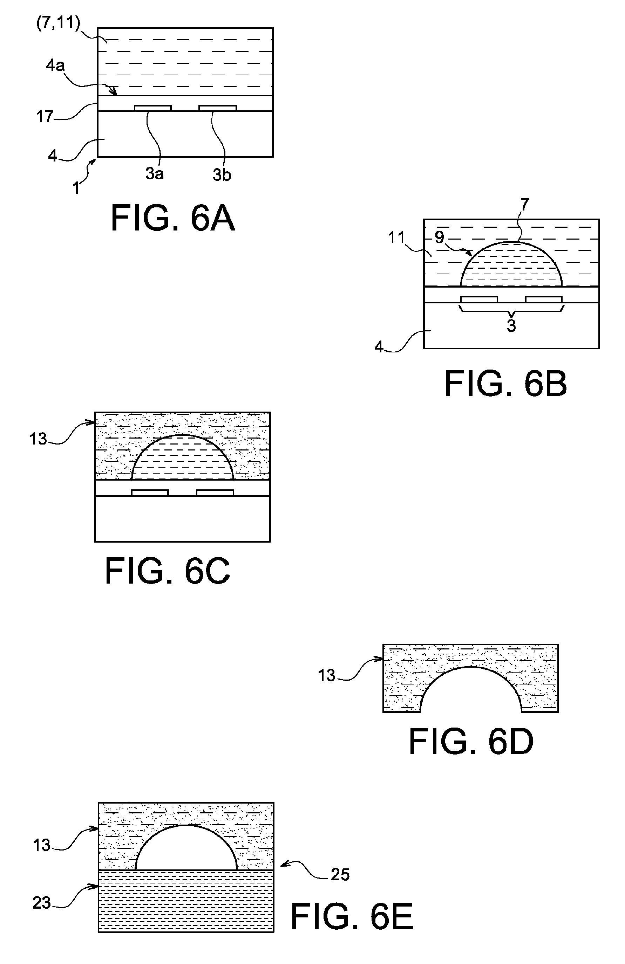

Les Figs. 6A-6E illustrent de manière schématique un procédé de réalisation d'un réseau microfluidique, selon un deuxième mode de réalisation de l'invention, en référence à une coupe transversale de la puce microfluidique de la Fig. 4.

Selon ce deuxième mode de réalisation, le deuxième liquide 11 est non miscible au premier liquide 7 de sorte que l'interface entre les deux liquides prend la forme de la structure fluidique 9 lors de l'actionnement du premier liquide 7 par LDEP.

A titre d'exemple, le premier liquide 7 est de l'eau, de l'eau déionisée EDI, un liquide organique (par exemple de l'huile), une solution aqueuse ou un solvant de type éthanol, acétone, ou glycérol. Le deuxième liquide 11 est en matériau possédant une propriété de durcissement ou de solidification et de préférence, on choisit un deuxième liquide avec une permittivité diélectrique assez différente de celle du premier liquide afin que l'actionnement du premier liquide 7 par LDEP soit optimal.

Selon une première étape, on place les premier et deuxième liquides 7, 11 non miscibles sur la surface libre 4a du substrat 4. A titre d'exemple, on réalise d'abord un bain du deuxième liquide 11 (par exemple, de la paraffine) sur la puce microfluidique 1 (Fig. 6A) et ensuite, on met ou on injecte dans ce bain le premier liquide 7 (par exemple, de l'eau).

Ensuite, on active le réseau d'électrodes 3 en lui appliquant une tension adaptée pour générer un champ électrique oscillant et non uniforme de manière à actionner par LDEP le premier liquide 7. Plus spécifiquement, l'interface entre les deux liquides est mise en forme par les forces de diélectrophrèse liquide actionnant le déplacement du premier liquide 7 sur le chemin défini par les électrodes 3a, 3b activés. Ainsi, l'interface entre les premier et deuxième liquides 7, 11 prend la forme de la structure fluidique 9 formée par le premier liquide 7.

Lorsque la géométrie de la structure fluidique 9 voulue a été formée, on fige le deuxième liquide 11 recouvrant la structure fluidique 9 par un processus de durcissement, de solidification ou de changement de phase tout en maintenant le réseau d'électrodes 3 en activation. Le matériau du deuxième liquide 11 va ainsi mémoriser la forme de la structure fluidique 9 ou autrement dit, l'empreinte de la structure fluidique 9 va se retrouver dans le matériau du deuxième liquide 11 durci formant ainsi le réseau fluidique 13 (Fig. 6C).

Ensuite, le réseau microfluidique 13 solidifié ou durci est décollé de la puce microfluidique 1 (Fig. 6D).

La Fig. 6E montre que le réseau microfluidique 13 est assemblé à un autre support 23 pour réaliser un composant microfluidique 25. Ensuite, un ou plusieurs trous peuvent être réalisés dans l'assemblage du composant microfluidique pour créer un dispositif microfluidique avec une ou plusieurs entrées fluidiques.

Le procédé selon l'invention permet ainsi de fabriquer des dispositifs microfluidiques pour toutes les applications qui utilisent la microfluidique. Parmi ces applications, on peut particulièrement citer la fabrication des vannes ou pompes péristaltiques « Quake » car des canaux à section semi-circulaire sont pratiquement indispensables pour adresser ce genre d'application.

En outre, on notera que l'invention peut être utilisée pour faire du prototypage rapide avec des puces microfluidiques en PDMS, pour adresser par exemple l'ensemble des applications biologiques et chimiques.

Bien entendu, diverses modifications peuvent être apportées par l'homme du métier à l'invention qui vient d'être décrite, uniquement à titre d'exemples non limitatifs.

## Revendications

1. Procédé de réalisation d'un réseau microfluidique comportant au moins un canal de section semi-circulaire, **caractérisé en ce qu'**il comporte les étapes suivantes :
- mise en contact d'un premier liquide (7) avec un réseau d'électrodes (3) d'une puce microfluidique (1) comprenant au moins une paire d'électrodes (3a, 3b) sensiblement parallèles et coplanaires disposées sur un substrat (4),
- activation dudit réseau d'électrodes de manière à actionner par diélectrophorèse liquide LDEP ledit premier liquide pour former une structure fluidique (9) comprenant au moins un doigt fluidique (9a), et
- utilisation de ladite structure fluidique comme un moule pour réaliser ledit réseau microfluidique par solidification ou durcissement d'un deuxième liquide (11) déposé sur la puce microfluidique et épousant la forme de ladite structure fluidique.

2. Procédé selon la revendication 1, **caractérisé en ce que** ledit premier liquide (7) possède une propriété de durcissement et **en ce que** ledit procédé comporte les étapes suivantes :
- durcissement dudit premier liquide matérialisant ladite structure fluidique (9) tout en maintenant le réseau d'électrodes (3) en activation pendant l'étape de durcissement afin de figer ladite structure fluidique, et
- écoulement du deuxième liquide (11) sur ladite structure fluidique figée.

3. Procédé selon la revendication 2, **caractérisé en ce que** le premier liquide (7) est un matériau à changement de phase liquide-solide sélectionné parmi les matériaux suivants : colle à base d'époxy ou de silicone ou de résine, colle UV, gel, polymère réticulant, paraffine, agarose, gélatine, cires, et wax.

4. Procédé selon la revendication 2 ou 3, **caractérisé en ce que** le premier liquide (7) est une colle UV et **en ce que** le durcissement dudit premier liquide est réalisé par insolation sous un rayonnement UV à une longueur d'onde adaptée à la longueur d'onde de réticulation de ladite colle UV.

5. Procédé selon l'une quelconque des revendications 2 à 4, **caractérisé en ce qu'**il comporte une étape de fusion du matériau durci ou solidifié dudit premier liquide afin de reconfigurer la structure fluidique.

6. Procédé selon la revendication 1, **caractérisé en ce que** le deuxième liquide (11) est non miscible au premier liquide (7) de sorte que l'interface entre les deux liquides prend la forme de ladite structure fluidique (9) sous l'effet de l'activation dudit réseau d'électrodes, le premier liquide étant recouvert par le deuxième liquide.

7. Procédé selon la revendication 6, **caractérisé en ce que** le premier liquide (7) est de l'eau déionisée EDI, de l'eau, un liquide organique, un solvant, ou une solution aqueuse.

8. Procédé selon l'une quelconque des revendications précédentes, **caractérisé en ce que** le deuxième liquide (11) est un matériau à changement de phase liquide-solide sélectionné parmi les matériaux suivants : polymères réticulants, paraffine, agarose, gélatine, cires, wax, colle à base d'époxy ou de silicone ou de résine, colle UV, et gel.

9. Procédé selon l'une quelconque des revendications précédentes, **caractérisé en ce que** la géométrie du réseau microfluidique est programmable par l'activation des électrodes de manière indépendante.

10. Procédé selon l'une quelconque des revendications précédentes, **caractérisé en ce que** la forme et/ou les dimensions dudit au moins un doigt fluidique (9a) du réseau microfluidique est configurable en fonction de la forme et/ou la largeur et/ou le nombre d'électrodes.

11. Procédé selon l'une quelconque des revendications précédentes, **caractérisé en ce qu'**au cours d'un même actionnement par diélectrophorèse liquide, ledit au moins un doigt fluidique pouvant être réalisé avec des dimensions variables.

12. Procédé selon l'une quelconque des revendications précédentes, **caractérisé en ce que** ledit réseau microfluidique est utilisé comme plaque modèle pour réaliser d'autres réseaux microfluidiques.

13. Procédé de réalisation d'un réseau microfluidique comportant au moins un canal de section semi-circulaire, **caractérisé en ce qu'**il comporte les étapes suivantes :
- placement d'une goutte mère d'un premier liquide (7) possédant une propriété de durcissement sur une position initiale d'un réseau d'électrodes (3) comprenant au moins une paire d'électrodes sensiblement parallèles et coplanaires disposées sur un substrat d'une puce microfluidique,
- activation dudit réseau d'électrodes de manière à actionner par diélectrophorèse liquide LDEP ledit premier liquide pour former une structure fluidique (9) comprenant au moins un doigt fluidique,
- durcissement dudit premier liquide matérialisant ladite structure fluidique tout en maintenant le réseau d'électrodes en activation afin de figer ladite structure fluidique,
- écoulement d'un deuxième liquide (11) sur la puce microfluidique recouvrant ladite structure fluidique figée,
- durcissement du deuxième liquide pour réaliser le réseau microfluidique, et
- démoulage du réseau microfluidique.

14. Procédé de réalisation d'un réseau microfluidique comportant au moins un canal de section semi-circulaire, **caractérisé en ce qu'**il comporte les étapes suivantes :
- placement des premier et deuxième liquides (7, 11) non miscibles sur une surface libre d'une puce microfluidique comprenant un réseau d'électrodes (3) ayant au moins une paire d'électrodes sensiblement parallèles et coplanaires, le deuxième liquide (11) possédant une propriété de durcissement,
- activation dudit réseau d'électrodes de manière à actionner par diélectrophorèse liquide LDEP ledit premier liquide pour former une structure fluidique comprenant au moins un doigt fluidique (9a), l'interface entre les premier et deuxième liquides prenant la forme de ladite structure fluidique,
- durcissement dudit deuxième liquide recouvrant ladite structure fluidique tout en maintenant le réseau d'électrodes en activation de sorte que l'empreinte de la structure fluidique se retrouve dans le deuxième liquide durci formant ainsi le réseau fluidique, et
- décollement du réseau microfluidique de la puce microfluidique.

15. Procédé de réalisation d'un composant microfluidique en utilisant le réseau microfluidique réalisé selon l'une quelconque des revendications précédentes, **caractérisé en ce qu'**il comporte les étapes suivantes :
- assemblage du réseau microfluidique (13) à un support (23) pour réaliser un composant microfluidique (25), et
- réalisation d'au moins un trou (26a) dans ledit assemblage pour créer une entrée fluidique.
